# EUROPÄISCHE PATENTSCHRIFT

(11) **EP 0 805 559 B1**
(45) Veröffentlichungstag und Bekanntmachung des Hinweises auf die Patenterteilung: **27.11.2013**
(21) Anmeldenummer: 97106966.1
(22) Anmeldetag: 25.04.1997
(51) Int. Cl.: H03K 19/003, H03K 19/017, H03K 5/1534

(54) **Treiberstufe**
Driver stage
Etage d'attaque

(30) Priorität: 29.04.1996 DE 19617173
(43) Veröffentlichungstag der Anmeldung: 05.11.1997
(73) Patentinhaber: Infineon Technologies AG, 85579 Neubiberg (DE)
(72) Erfinder: Sommer, Diether, Dipl.-Phys., 80469 München (DE); Mitteregger, Gerhard, 5761 Maria Alm (AT); Savignac, Dominique, Dr.rer.nat., 85737 Ismaning (DE); Mukundarajan, Suraj, 349249 Singapora (SG)
(74) Vertreter: Jannig, Peter

(56) Entgegenhaltungen:
- EP-A- 0 360 525
- EP-A- 0 443 434
- EP-A- 0 666 648
- US-A- 5 086 238
- US-A- 5 128 555
- US-A- 5 414 312

## Beschreibung

Die Erfindung betrifft eine Treiberstufe gemäß dem Oberbegriff des Anspruchs 1.

Eine derartige Treiberstufe, welche als CMOS-Inverterstufe ausgebildet ist, ist z.B. in Tietze/Schenk Halbleiterschaltungstechnik, 8. Auflage 1986 auf Seite 211ff beschrieben. Die Abbildung 9.36 zeigt einen CMOS-Inverter. Die Ausgangsspannung eines derartigen Inverters ist in Abhängigkeit der Eingangsspannung entweder gleich der Versorgungsspannung V_{DD} oder gleich Masse, da immer einer der beiden Transistoren T1 oder T2 leitend geschaltet ist.

Aufgrund der steigenden Taktfrequenzen und EMV Anforderungen in Mikrocontrolleranwendungen stellen Störungen auf den Versorgungsleitungen, verursacht durch schnelles Schalten großer Ströme, zunehmend ein Problem bei der Schaltungsentwicklung dar.

Im Zusammenwirken der Induktivitäten der Pins und Bonddrähte mit den stets vorhandenen Kapazitäten werden durch schnelles Schalten der Treiberstufen Störschwingungen angeregt, die besonders dann, wenn Analog- und Digitalteile auf einem Chip realisiert werden, zu einer Fehlfunktion führen können. Darüberhinaus kommt es an den Pins zur Abstrahlung elektromagnetischer Wellen, die die Funktion anderer Bauteile beeinträchtigen können.

Messungen haben gezeigt, daß die Takttreiber der Mikrocontroller die Hauptquelle, sowohl für die leitungsgeführten, als auch für die abgestrahlten Störungen darstellen.

Für 8-Bit Mikrocontroller wird z.B. ein Taktsystem mit nichtüberlappenden Takten verwendet, in dem die Größe der Nichtüberlappzeit zum größten Teil von der Schaltzeit des Takttreibers bestimmt wird. Die Schaltzeit der Takttreiber bzw. die Nichtüberlappzeit zwischen den Takten unterliegt Schwankungen aufgrund von Betriebsspannungs-, Temperatur- und Fertigungseinflüssen. Da die Nichtüberlappzeit, um die einwandfreie Funktion der Digitalstufen des Mikrocontrollers zu gewährleisten, einen Minimalwert nicht unterschreiten (1ns), als auch einen Maximalwert nicht überschreiten darf, gestaltet sich die Dimensionierung bei störempfindlichen Anwendungen mit großen Takttreiberlasten als problematisch, da mit der Forderung nach minimaler Nichtüberlappzeit bei den schnellsten Betriebsbedingungen die Takttreiber festgelegt sind. Bei störempfindlichen Anwendungen und großen Takttreiberlasten kann dann die Vergrößerung der Nichtüberlappzeit, der Anstiegs- und Abfallzeit der Takte bei den langsamsten Betriebsbedingungen die Forderung nach einer ausreichender Taktbreite bei einer bestimmten Taktfrequenz unerfüllbar machen. Bei kleineren Takttreiberlasten könnte eine Verringerung der Schwankung der Nichtüberlappzeit den Einsatz des Mikrocontrollers bei höheren Taktfrequenzen ermöglichen.

Aufgabe der vorliegenden Erfindung ist es daher eine Treiberstufe anzugeben, welche den vorgenannten Nachteil nicht aufweist.

Diese Aufgabe wird durch den kennzeichnenden Teil des Anspruchs 1 gelöst.

Vorteil der Erfindung ist es, daß durch die Verwendung von zwei voneinander getrennten Ansteuerschaltungen mit jeweilig zugeordneten Spannungsreglern für den jeweiligen Schalttransistor der Inverterstufe zum einen Einflüsse der Versorgungsspannung ausgeglichen werden und zum anderen gegenseitige Einflüsse der beiden Treiberstufen vermieden werden.

Ein weiterer Vorteil ergibt sich durch die Verwendung eines Pulsgenerators, welcher für ein besonders schnelles Schalten der jeweiligen Schalttransistoren verantwortlich ist. Dabei werden Störungen nicht vermieden sondern durch geeignete Dimensionierung des Vortreibertransistors den Erfordernissen angepaßt. Eine geeignete Wahl des Vortreibertransistors und Haupttreibertransistors ergibt vorteilhafterweise einen gaußförmigen Verlauf.

Ein weiterer Vorteil besteht in dem besonders geringen Schaltungsaufwand und der zuverlässigen Arbeitsweise auch bei hohen Frequenzen.

Die Erfindung wird nachfolgend anhand von vier Figuren näher erläutert.

Es zeigen:
- Figur 1: ein Prinzipschaltbild der erfindungsgemäßen Anordnung,
- Figur 2 und 3: Ausführungsformen der in Figur 1 gezeigten Pulsgeneratoren,
- Figur 4: einen zeitlichen Verlauf des Ansteuersignals für den Ausgangstransistor.

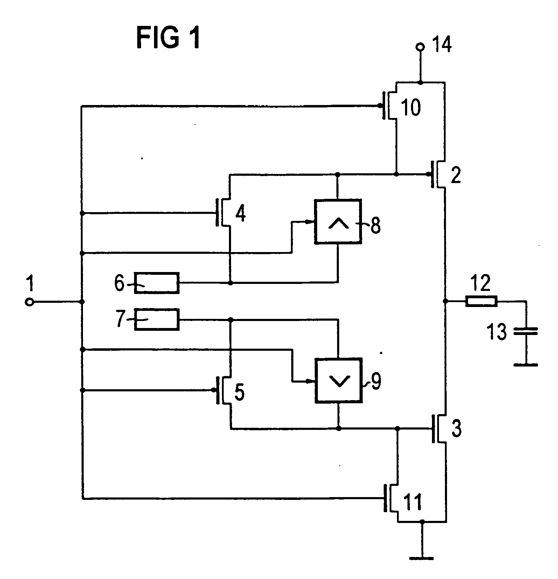

In Figur 1 ist mit 1 eine Eingangsklemme bezeichnet, der das zu treibende Taktsignal zugeführt wird. Diese Eingangsklemme ist mit dem Gateanschluß eines p-Kanal-FETS 10 und dem Gateanschluß eines n-Kanal-FETS 4 verschaltet. Die Laststrecke des n-Kanal-FETS 4 ist zum einen mit der Laststrecke des p-Kanal-FETS 10 sowie dem Gateanschluß eines p-Kanal-Ausgangs-FETS 2 verbunden. Der andere Laststreckenanschluß des p-Kanal-FETS 10 ist mit der Versorgungsspannungsklemme 14 verschaltet. Der andere Laststreckenanschluß des n-Kanal-FETS 4 ist mit dem Ausgang eines ersten Spannungsreglers 6 verbunden. Der Spannungsregler 6 speist des weiteren einen ersten Pulsgenerator 8 dessen Ausgangssignal ebenfalls dem Steueranschluß des p-Kanal-Ausgangs-FETS 2 zugeführt wird. Der Pulsgenerator 8 wird durch das an der Eingangsklemme 1 anliegende Signal gesteuert.

Des weiteren ist die Eingangsklemme 1 zum einen mit dem Gateanschluß eines p-Kanal-FETS 5 sowie mit dem Gateanschluß eines n-Kanal-FETS 11 verschaltet. Die Laststrecke des p-Kanal-FETS 5 ist mit der Laststrecke des n-Kanal-FETS 11 sowie mit dem Steueranschluß eines n-Kanal-Ausgangs-FETS 3 verbunden. Der andere Laststreckenanschluß des n-Kanal-FETS 11 ist mit Masse verschaltet. Der andere Laststreckenanschluß des p-Kanal-FETS 5 ist mit dem Ausgang eines zweiten Spannungsreglers 7 verbunden. Das Ausgangssignal des Spannungsreglers 7 wird außerdem einem zweiten Pulsgenerator 9 zugeführt, der wiederum durch das an der Eingangsklemme 1 anliegende Eingangssignal gesteuert wird und dessen Ausgangssignal dem Gateanschluß des n-Kanal-Ausgangs-FETS 3 zugeführt wird.

Die Laststrecke des p-Kanal-Ausgangs-FETS 2 ist zum einen mit der Versorgungsspannungsklemme 14 verschaltet und zum anderen mit der Laststrecke des n-Kanal-Ausgangs-FETS 3. Dessen anderer Laststreckenanschluß ist mit Masse verschaltet. Am Knotenpunkt der Reihenschaltung der Laststrecken der beiden Ausgangs-FETS 2, 3 ist eine Last gegen Masse verschaltet, die symbolisch aus der Reihenschaltung eines Widerstands 12 und einer Kapazität 13 besteht.

Die Transistoren 2 und 3 stellen die jeweiligen Treibertransistoren dar. Im Layout werden diese großen Transistoren aus mehreren kleinen parallel geschalteten Transistoren aufgebaut. Neben diesen Treibertransistoren 2, 3 befinden sich direkt vom Eingangssignal gesteuerte Abschalttransistoren 10 und 11. Mit diesen kann der jeweils nicht benötigte Treibertransistor schnell ausgeschaltet werden und dadurch eine fast völlige Querstromfreiheit erreicht werden. Ihre Realisierung im Layout erfolgt ähnlich wie bei den Treibertransistoren, wobei jedem parallelgeschalteten Treibertransistor ein derartiger Abschalttransistor zugeordnet wird.

Die eigentliche Funktionsweise wird nachfolgend für einen Ausgangstransistor, nämlich den Ausgangs-FET 2, näher beschrieben. Die Funktionsweise für den spiegelbildlichen Schaltungsteil betreffend den Ausgangs-FET 3 entspricht dieser.

Die eigentliche Vortreiberschaltung besteht aus dem Vortreibertransistor 4 für den Ausgangstransistor 2, bzw. dem Vortreibertransistor 5 für den Ausgangstransistor 3. Mit 8 bzw. 9 ist jeweils ein Pulsgenerator bezeichnet, der später näher beschrieben wird.

Steigt das Signal an der Eingangsklemme 1 von "0" nach "1", so werden sowohl der Transistor 4 wie auch der Pulsgenerator 8 angesteuert. Beide Elemente werden dabei durch den Spannungsregler 6 versorgt.

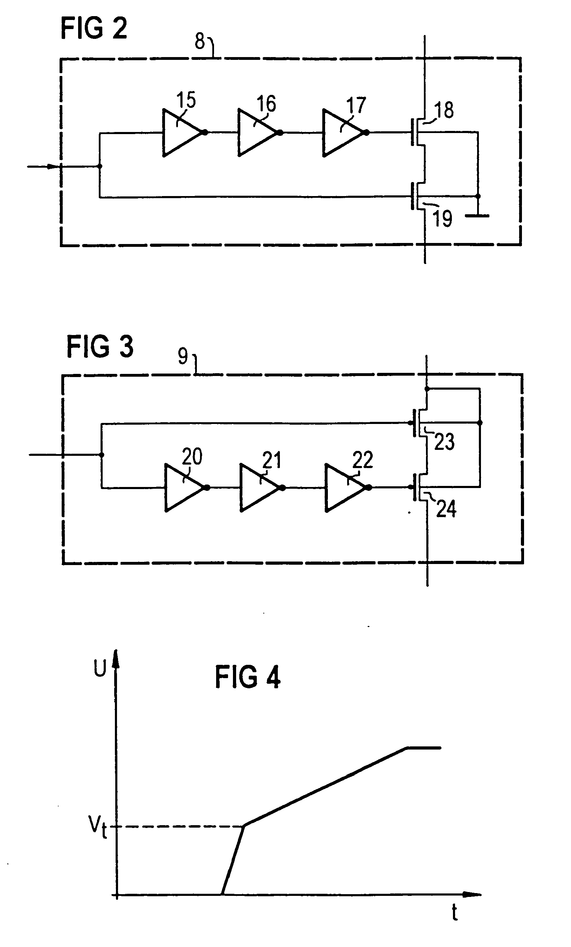

In Figur 4 ist der Spannungsverlauf an dem Gateanschluß des Transistors 3 über die Zeit dargestellt, der durch diese Schaltungskombination erzeugt wird. Der Pulsgenerator 8 erzeugt zuerst einen starken Spannungsanstieg bis zur Spannung Vₜ. Dann endet der Impuls. Zu diesem Zeitpunkt ist der Transistor 4 ebenfalls leitend geschaltet und die Spannung am Gate des Ausgangs-FETS 2 steigt nun mit einem entsprechend flacheren Anstieg weiter an. Durch geeignetes Einstellen des Spannungsverlaufs, nimmt der Ausgangsstrom des Taktsignals durch die RC-Last 12, 13 einen praktisch gaußförmigen Verlauf an.

In Figur 2 und 3 sind Ausführungsformen für die Pulsgeneratoren 8 und 9 dargestellt. Diese sind für die Beschleunigung des Schaltens der Takttreiber bei weitestgehend gleichem Störaufkommen verantwortlich. Das Ansteuersignal wird zum einen über eine Reihenschaltung von drei Invertern 15, 16, 17 dem Gateanschluß eines n-Kanal-FETS 18 zugeführt und zum anderen direkt dem Gateanschluß eines weiteren n-Kanal-FETS 19.

Die Laststrecken der beiden n-Kanal-FETS 18, 19 sind in Reihe geschaltet, wobei an einem Anschluß das Ausgangssignal abgreifbar ist und dem anderen Anschluß das Ausgangssignal des Spannungsreglers 6 zugeführt wird. Die Substratanschlüsse der FETS 18 und 19 sind mit Masse verschaltet.

Ebenso wird in Figur 3 das Eingangssignal von der Eingangsklemme 1 zum einen direkt einem Gateanschluß eines p-Kanal-FETS 23 und zum anderen über eine Reihenschaltung aus drei Invertern 20, 21, 22 dem Gateanschluß eines weiteren p-Kanal-FETS 24 zugeführt. Auch die Laststrecken dieser beiden FETS 23, 24 sind in Reihe geschaltet, wobei die Reihenschaltung einerseits mit der geregelten Ausgangsspannung des Spannungsreglers 7 beaufschlagt wird und andererseits das Ausgangssignal abgreifbar ist. Die Substratanschlüsse der beiden FETS 23 und 24 werden ebenfalls mit der geregelten Ausgangsspannung des Spannungsreglers 7 beaufschlagt.

Liegt an der Eingangsklemme 1 ein logisches "0"-Signal an, so ist Transistor 19 sperrend und Transistor 18 leitend geschaltet. Geht das Signal an der Eingangsklemme 1 von "0" nach "1", so wird Transistor 19 ebenfalls leitend geschaltet und das Ausgangssignal des Spannungsreglers 6 wird über die Laststrecken der zu diesem Zeitpunkt leitenden Transistoren 18 und 19 an das Gate des Ausgangstransistors 2 geschaltet. Die drei Inverter 15, 16, 17 bilden eine Verzögerungskette, welche das Eingangssignal an der Eingangsklemme 1 verzögert auf das Gate des Transistors 18 schalten. Nach der durch die drei Inverterstufen 15, 16, 17 definierten Verzögerungszeit gelangt nun das Eingangssignal der Eingangsklemme 1 an das Gate des Transistors 18. Dadurch wird dieser gesperrt, wodurch der zuvor erwähnte Impuls erzeugt wird.

Der Spannungsregler 6 erzeugt eine Spannung, welche immer eine konstante Differenz zur Versorgungsspannung V_{DD} aufweist. Der Spannungsregler 7 hingegen erzeugt eine Spannung die immer eine konstante Differenz zu Vₛₛ aufweist.

Die Verzögerungszeit kann beliebig durch Wahl der Anzahl von Inverterstufen ausgewählt werden oder durch eine gleichwertige Verzögerungsschaltung ersetzt werden. Wesentlich ist nur, daß das zu verzögernde Ansteuersignal invertiert wird.

## Patentansprüche

1. Treiberstufe mit zwei Ausgangsfeldeffekttransistoren (2, 3) vom entgegengesetzten Leitungstyp, deren Laststrecken zwischen Versorgungsspannung und Masse geschaltet sind, wobei das Ausgangssignal am Knotenpunkt der Reihenschaltung der Laststrecken der beiden Ausgangsfeldeffekttransistoren (2, 3) abgreifbar ist, und wobei die Steueranschlüsse der Ausgangsfeldeffekttransistoren (2, 3) jeweils über die Laststrecke eines weiteren Feldeffekttransistors (4, 5) vom jeweils entgegengesetzten Leitungstyp mit dem Ausgang jeweils eines Spannungsreglers (6, 7) verschaltet sind und das zu treibende Signal dem Steueranschluß des weiteren Feldeffekttransistors (4, 5) zugeführt wird,
**dadurch gekennzeichnet,**
**daß** ein Pulsgenerator (8, 9) vorgesehen ist, der von dem jeweiligen Spannungsregler (6, 7) gespeist wird und durch das Eingangssignal (1) gesteuert wird und einen Ausgangspuls erzeugt, der dem Gateanschluß des Ausgangsfeldeffekttransistors (2, 3) zugeführt wird, und
**daß** der Spannungsregler (6, 7) eine Spannung erzeugt, welche immer eine konstante Differenz zur Versorgungsspannung bzw. zu Masse aufweist.

2. Treiberstufe nach Anspruch 1,
**dadurch gekennzeichnet,**
**daß** zwischen Steueranschluß des Ausgangsfeldeffekttransistors (2, 3) und Versorgungsspannungsklemme bzw. Masse die Laststrecke eines Abschalttransistors (10, 11) vorgesehen ist, dessen Steueranschluß mit dem Eingangssignal (1) beaufschlagt wird.

3. Treiberstufe nach Anspruch 1 oder 2,
**dadurch gekennzeichnet,**
**daß** der Pulsgenerator (8, 9) durch zwei weitere Feldeffekttransistoren (18, 19; 23, 24) gebildet wird, die vom zum Leitungstyp des Ausgangsfeldeffekttransistor (2; 3) entgegengesetzten Leitungstyp sind und deren Laststrecken in Reihe geschaltet sind, wobei der Laststrecke einerseits die geregelte Spannung des jeweiligen Spannungsreglers (6; 7) zugeführt wird und an der Laststrecke andererseits das Ausgangssignal abgreifbar ist, und wobei der Steueranschluß des einen weiteren Feldeffekttransistors (18, 19; 23, 24) direkt mit dem Eingangssignal (1) beaufschlagt wird und der Steueranschluß des anderen weiteren Feldeffekttransistors (18, 19; 23, 24) über ein invertierendes Verzögerungsglied (15, 16, 17; 20, 21, 22) mit dem Eingangssignal (1) beaufschlagt wird.

## Claims

1. Driver stage having two output field effect transistors (2, 3) of the opposite conduction type, the load paths of which are connected between a supply voltage and earth, the output signal being able to be tapped off at the node of the series circuit of the load paths of the two output field effect transistors (2, 3), and the control connections of the output field effect transistors (2, 3) each being connected to the output of a respective voltage regulator (6, 7) via the load path of a further field effect transistor (4, 5) of the respectively opposite conduction type, and the signal to be driven being supplied to the control connection of the further field effect transistor (4, 5),
**characterized**
**in that** a pulse generator (8, 9) is provided, which pulse generator is fed by the respective voltage regulator (6, 7), is controlled by the input signal (1) and generates an output pulse which is supplied to the gate connection of the output field effect transistor (2, 3), and
**in that** the voltage regulator (6, 7) generates a voltage which always has a constant difference from the supply voltage or from earth.

2. Driver stage according to Claim 1,
**characterized**
**in that** the load path of a disconnection transistor (10, 11) is provided between the control connection of the output field effect transistor (2, 3) and the supply voltage terminal or earth, the input signal (1) being applied to the control connection of said disconnection transistor.

3. Driver stage according to Claim 1 or 2,
**characterized**
**in that** the pulse generator (8, 9) is formed by two further field effect transistors (18, 19; 23, 24) which are of the conduction type opposite to the conduction type of the output field effect transistor (2; 3) and the load paths of which are connected in series, the regulated voltage from the respective voltage regulator (6; 7) being supplied to the load path, on the one hand, and the output signal being able to be tapped off at the load path, on the other hand, and the input signal (1) being directly applied to the control connection of the one further field effect transistor (18, 19; 23, 24), and the input signal (1) being applied to the control connection of the other further field effect transistor (18, 19; 23, 24) via an inverting delay element (15, 16, 17; 20, 21, 22).

## Revendications

1. Étage d'attaque comportant deux transistors à effet de champ de sortie (2, 3) de types de conductivité opposés, dont les trajets de charge sont connectés entre la tension d'alimentation et la masse, dans lequel le signal de sortie peut être prélevé au niveau du point de jonction du circuit série des trajets de charge des deux transistors à effet de champ de sortie (2, 3), et dans lequel les bornes de commande des transistors à effet de champ de sortie (2, 3) sont respectivement connectés par l'intermédiaire du trajet de charge d'un transistor à effet de champ supplémentaire (4, 5) du type de conductivité opposé respectif à la sortie d'un régulateur de tension respectif (6, 7), et le signal d'attaque est fourni à la borne de commande du transistor à effet de champ supplémentaire (4, 5),
**caractérisé en ce qu'**il est prévu un générateur d'impulsions (8, 9) qui est alimenté par le régulateur de tension respectif (6, 7) et est commandé par le signal d'entrée (1) et génère une impulsion de sortie qui est fournie à la grille du transistor à effet de champ de sortie (2, 3), et
**en ce que** le régulateur de tension (6, 7) génère une tension qui présente toujours une différence constante par rapport à la tension d'alimentation ou à la masse.

2. Etage d'attaque selon la revendication 1,
**caractérisé en ce qu'**entre la borne de commande du transistor à effet de champ de sortie (2, 3) et la borne de tension d'alimentation ou la masse, se trouve le trajet de charge d'un transistor de coupure (10, 11) à la borne de commande duquel est appliqué le signal d'entrée (1).

3. Etage d'attaque selon la revendication 1 ou 2,
**caractérisé en ce que** le générateur d'impulsions (8, 9) est formé par deux transistors à effet de champ supplémentaires (18, 19 ; 23, 24) qui sont d'un type de conductivité opposé au type de conductivité du transistor à effet de champ de sortie (2 ; 3) et dont les trajets de charge sont connectés en série, dans lequel d'une part, la tension régulée est fournie au trajet de charge du régulateur de tension respectif (6 ; 7) et d'autre part, le signal de sortie peut être prélevé au niveau du trajet de charge, et dans lequel le signal d'entrée (1) est directement appliqué à la borne de commande dudit autre transistor à effet de champ supplémentaire (18, 19 ; 23, 24), et le signal d'entrée (1) est appliqué à la borne de commande de l'autre transistor à effet de champ supplémentaire (18, 19 ; 23, 24) par l'intermédiaire d'un élément à retard inverseur (15, 16, 17 ; 20, 21, 22).
